# EUROPEAN PATENT APPLICATION

(11) **EP 4 852 621 A1**
(43) Date of publication of application: **09.12.2026**
(21) Application number: 25180822.6
(22) Date of filing: 04.06.2025
(51) Int. Cl.: H05K 1/02, H02M 1/44, H05K 1/14, H05K 1/16

(54) **ASSEMBLY WITH A FREQUENCY-DEPENDENT FILTER ELEMENT AND METHOD FOR DESIGNING AN ASSEMBLY**

(71) Applicant: Bayerische Motoren Werke Aktiengesellschaft, 80809 München (DE)
(72) Inventor: Greuet, Jean-Baptiste, 85635 Höhenkirchen (DE); Schultheiss, Friedrich, 80993 München (DE)

(57) **Abstract**

An assembly (10) has a housing (18), at least one circuit substrate (12), at least one electronic component (14) emitting disturbing electromagnetic emissions, and at least one frequency-dependent filter element (16) which filters disturbing electromagnetic emissions emitted from the electronic component (14). The frequency-dependent filter element (16) has a stack (22) of at least two electrically conductive capacitance-forming elements (24) arranged above each other and separated by a dielectric layer (26), and at least one electrically conductive connection element (28). The capacitance-forming elements (24) are mechanically coupled by the at least one electrically conductive connection element (28) to each other, to the circuit substrate (12) and/or to the housing (18). Each of the electrically conductive capacitance-forming elements (24) together with the respective at least one electrically conductive connection element (28) is part of a separate notch filter (32) attuned to a specific frequency. The assembly (10) is designed by determining the disturbing electromagnetic emissions of an electric circuit (20) with at least one electronic component (14) on a circuit substrate (12), generating an equivalent circuit diagram (30) with at least two notch filters (32) that is suitable for reducing the disturbing frequency electromagnetic emissions, and transferring the equivalent circuit diagram (30) into the frequency-dependent filter element (16).

## Description

The invention relates to an assembly with a housing, at least one circuit substrate, at least one electronic component emitting disturbing electromagnetic emissions and at least one frequency-dependent filter element, which filters disturbing frequency emissions emitted from the electronic component, and to a method for designing such an assembly.

Electronic circuits, e.g. in a battery electric vehicle, often generate disturbing electromagnetic emissions during operation. It is desired to reduce these electromagnetic emissions.

A well-known filtering technique is using band pass filters with a dedicated low impedance path to ground via a capacitor. This is, however, cost intensive.

It is an object of the invention to reduce disturbing electromagnetic emissions of a component of an electrical circuit in a cost-efficient and reliable manner.

This object is achieved with an assembly comprising a housing, at least one circuit substrate, at least one electronic component emitting disturbing electromagnetic emissions and at least one frequency-dependent filter element, which filters disturbing electromagnetic emissions emitted from the electronic component. The at least one circuit substrate is accommodated in the housing, and the at least one electronic component is mounted on the circuit substrate. The frequency-dependent filter element comprises a stack of at least two electrically conductive capacitance-forming elements arranged above each other and separated by a dielectric layer, and at least one electrically conductive connection element, the at least two electrically conductive capacitance-forming elements being mechanically coupled by the at least one electrically conductive connection element to each other, to the circuit substrate and/or to the housing. Each of the electrically conductive capacitance-forming elements together with the respective at least one electrically conductive connection element is part of a separate notch filter attuned to a specific frequency.

This ensemble of notch filters can also be regarded as one notch filter with several cascaded filter stages.

The capacitance-forming elements each extend over a certain area to be able to form a parasitic capacitance. E.g., the capacitance-forming elements are plate-shaped. As a rule, to form a suitable parasitic capacitance, capacitance-forming elements adjacent in the stack overlap over a sufficient area in a top view.

The capacitance-forming elements and dielectric layers act e.g. as parasitic capacitances, while the connection elements act e.g. as parasitic inductances. Usually, none of these components are part of the electric circuit containing the electronic component emitting the disturbing electromagnetic emissions or of another specific electric circuit.

None of the components of the high frequency-dependent element need to be a specific electronic part. All components can be low-cost standard mounting or connection parts. These non-specific capacitance-forming elements, dielectric layers and connection elements are far cheaper than specific electronic components. By combining naturally occurring parasitic capacities and inductances in the capacitance-forming elements, connection elements and optionally dielectric layers, it is possible to create a frequency-dependent element that blocks a sufficiently wide frequency range.

By varying the size, material, thickness, distance, number and/or arrangement of the electrically conductive capacitance-forming elements, the connection elements and optionally the dielectric layers, it is possible to fine-tune the electromagnetic characteristics of each of the notch filters. When several notch filters are combined, the filtered frequency range may be defined with a sufficient accuracy. This allows attuning the frequency-dependent filter element to a specific frequency range relevant to a specific electric circuit or electronic component, ensuring flexible and precise noise suppression.

Also, there is less need for expensive, dedicated inductors or capacitors in the electric circuit. This reduces manufacturing costs while maintaining a performance comparable to more expensive, specialized filtering components. In one aspect, one or more Y-capacitors and/or dedicated electronic filter components may be omitted in the electric circuit, thereby further reducing the costs of the assembly.

In one aspect, the frequency-dependent filter element is configured to reduce a disturbing current originating in the electric circuit comprising the electronic component and flowing through the frequency-dependent filter element to the housing. In this way, electric currents flowing through the housing and interfering with other electric circuits may be significantly reduced.

The circuit substrate carrying the electronic component emitting disturbing electromagnetic emissions, as a rule, is connected to ground, e.g. by the housing. The frequency-dependent filter element may be connected between the electronic component emitting disturbing electromagnetic emissions and ground so that the electromagnetic emissions are prevented from being coupled into the housing.

The circuit substrate is e.g. a printed circuit board, an IMS, a ceramic carrier plate or any other suitable mechanical carrier for electronic components.

By providing several notch filters, e.g. in series, in the frequency-dependent filter element, it is possible to confine the disturbing currents largely to the electric circuit containing the electronic components and the circuit substrate, resulting in short current loops that do not affect other electronic circuits and components distanced from the noise-emitting electronic component.

In one variant, the assembly is part of an electronic unit in a vehicle. The vehicle may be an electric vehicle that is at least temporarily electrically powered. Such vehicles commonly contain power electronics and high-voltage components that typically generate strong disturbing electromagnetic emissions. By incorporating the frequency-dependent filter element, electromagnetic compatibility is increased and potential disruptions to other onboard electronic systems are reduced.

The disturbing component may be part of a power electronic and is e.g. a power switch such as a MOSFET or an IGBT that is operated at a predetermined switching frequency. The disturbance frequency may be any frequency, e.g. 10 kHz, 10 MHz, but also lower or higher. Also, disturbing frequencies may be distributed in a wide or narrow frequency band.

Optionally, the stack contains two, three, four or more capacitance-forming elements. This design is easily scalable for different filtering requirements. In applications where better noise attenuation is needed, additional capacitance-forming elements can be added without fundamentally altering the overall design of the assembly. This allows to flexibly customizing the frequency-dependent filter element's performance.

In one aspect, the frequency-dependent filter element is arranged so that the electrically conductive capacitance-forming elements are parallel to each other and stacked with the circuit substrate. A constant distance between the capacitance-forming elements and the circuit substrate facilitates determination of the parasitic impedance of a combination of capacitance-forming elements and connection elements and minimizes the volume of the assembly. Any other non-parallel arrangement is also possible.

The capacitance-forming elements are in one aspect close in size to the circuit substrate. This is especially beneficial in compact installations in automotive settings.

In order to optimize electromagnetic filtering, the stack of capacitance-forming elements may be placed directly adjacent to the circuit substrate. This close stacking arrangement also makes the entire assembly more robust and less susceptible to mechanical stress.

In one aspect, at least one of the electrically conductive connection elements mechanically connects the stack of at least two parallel electrically conductive plate-shaped elements with the housing. Thus, the number of components can be reduced, also reducing the weight of the assembly, and no parasitic characteristics of further connection elements have to be considered when determining the filtering effect.

The frequency-dependent filter element generally is galvanically isolated from any electric circuits and has the sole electrical function to deviate the disturbing electromagnetic emissions from a long path usually going through the housing or a reference ground plane located below the circuit substrate. Additionally, the frequency-dependent filter element may mechanically mount the circuit substrate carrying the noise-emitting electronic component to the housing. Optionally, no further fastening elements are necessary. Further, the frequency-dependent filter element may serve to dissipate thermal energy from the electric component to the housing. This effect may be enhanced by using a thermal dissipating material for one or more of the dielectric layers.

E.g., the electrically conductive capacitance-forming elements may comprise layers of a circuit substrate. On the smallest scale, the stack may be integrated into a circuit substrate. The electrically conductive capacitance-forming elements then may comprise conductive layers of a circuit substrate that are separated by a dielectric layer.

Correspondingly, the electrically conductive connection elements may for small-scale assemblies comprise conductive connections between layers of a circuit substrate.

In larger assemblies, e.g. in power electronics in a vehicle or a power station, the electrically conductive capacitance-forming elements may e.g. be realized as metal plates or partially metallized plates. The metal plates may consist of any suitable metal in any suitable thickness from thin foils and sheets to massive boards.

In this case, the electrically conductive connection elements in one aspect comprise electrically conductive screws, springs and/or clamps or any other mechanical mounting parts to connect two capacitance-forming elements to adjust the electric characteristics of the frequency-dependent filter element.

The parasitic inductance of a screw is e.g. dependent on a diameter, length, material and positioning of the screw on the capacitance-forming element. It is also possible to adjust the parasitic inductivity of a screw by choosing a suitable shape of the screw thread.

Correspondingly, the dielectric layers are chosen in size and material depending on the capacitance-forming elements. E.g. a dielectric layer may separate two electrically conductive layers in a circuit substrate. In larger scale assemblies, the dielectric layer usually has an area and thickness similar to area and thickness of the capacitance-forming elements. The dielectric layer may consist of any suitable material, e.g. a heat dissipating material, a plastic material, air, other gases or vacuum.

Further, any of the parts of the frequency-dependent filter element may be completely or partly covered by a suitable coating, e.g. to adjust an electric impedance of the respective component. This provides an additional parameter for adjusting the frequency range to be filtered.

All of these components are cheap and easily available in a great variety of sizes, designs and materials, giving a wide variety of options for naturally occurring parasitic capacities and inductances to be combined into suitable notch filters of the frequency-dependent filter element.

Usually, the connection elements only mechanically connect two directly adjacent capacitance-forming elements or only one capacitance-forming element to the circuit substrate or the housing. I.e., the connecting elements usually do not extend over more than two adjacent stacked capacitance-forming elements, however, this would also be possible.

Further, as a bypass and return path for the disturbance current, dedicated electronic bypass components may be placed in the electric circuit near the noise emitting electronic component to allow the emitted noise to be returned into the electric circuit. The disturbing electromagnetic emissions traveling through ground, e.g. through the housing, and to other electronic components are, therefore, further reduced. The noise emitting electronic component and the bypass components e.g. form a current loop for the disturbance current, such that the disturbance current is confined to the direct vicinity of the noise emitting electronic component. The electronic bypass components may exhibit a frequency-dependent impedance with a local minimum at the disturbance frequency range emitted by the noise emitting electronic component on the circuit substrate. In combination with the frequency-dependent filter element attenuating a similar frequency range, the disturbing current may be efficiently directed back into the electric circuit.

The above object is also achieved with a method for designing an assembly as described above, comprising the steps of:
- determining the disturbing electromagnetic emissions of an electric circuit with at least one electronic component on a circuit substrate,
- generating an equivalent circuit diagram with at least two notch filters that is suitable for reducing the disturbing electromagnetic emissions, and
- transferring the equivalent circuit diagram into a frequency-dependent filter element comprising a stack of at least two electrically conductive capacitance-forming elements arranged above each other and separated by a dielectric layer, and at least one electrically conductive connection element mechanically coupling the capacitance-forming elements to each other, to the circuit substrate and/or to a housing, such that the frequency-dependent filter element corresponds to the equivalent circuit diagram in its frequency-dependent filtering properties, wherein the electrically conductive capacitance-forming elements and the at least one electrically conductive connection element form parts of the respective notch filters.

The equivalent circuit diagram e.g. primarily contains parasitic capacitances and inductances suitable to filter the frequency range corresponding to the determined emissions.

In one aspect, the step of transferring the equivalent circuit diagram into the frequency-dependent filter element comprises selecting suitable electrically conductive capacitance-forming elements, connection elements and optionally dielectric layers, additional springs and/or coatings, from a predetermined data set with respect to capacitance, inductance, material, space requirements and/or a position of the respective component in the assembly. Any suitable further parameters can be considered as well.

The step of generating an equivalent circuit diagram may be performed by a computer program that e.g. outputs a serial configuration of a desired number of notch filters to attenuate a desired frequency range. E.g., a known circuit simulation software (e.g. APLAC^{®}) may be used to generate the equivalent circuit diagram. Also, an optimization routine may be used to find the components for the specific notch filters with the desired frequencies.

To facilitate the choice of the appropriate components, the step of transferring the equivalent circuit diagram into the frequency-dependent filter element may be carried out using a machine learning method. The machine learning method is e.g. a suitable artificial neuronal network or a large language model.

The predetermined data set may be used for suitably training of the machine learning model, e.g. by supervised learning. A suitably trained machine learning model is able to quickly find a fitting combination of components even from a big data set, thus reducing manufacturing time and costs.

As training data, the predetermined data set may be prepared to include parasitic capacitances and inductances for the multitude of different capacitance-forming elements, connection elements an, optionally, dielectric layers, coatings, springs and/or other mounting parts. The above multitude may contain the respective elements in different sizes, materials and/or at different positions in the frequency-dependent filter element. Further, the resulting filtered frequency range for selected combinations of capacitance-forming elements, connection elements and optionally dielectric layers and further components may be included in the training data.

The machine learning method also may be specifically trained with equivalent circuit diagrams containing different numbers of notch filters and examples of frequency-dependent filter elements assembled from capacitance-forming elements, dielectric layers and connection elements from the predetermined data set with a corresponding frequency-dependent filtering range.

In this approach, a simulation program is used to generate the equivalent circuit diagram and optimize the values of each component of the equivalent circuit diagram, e.g. via an optimization routine, focusing on a predetermined number of connected notch filters, and, in a separate step, a machine learning model is used to choose suitable components from a very large set of possible components to realize these notch filters from simple non-electronic parts. This allows creating a frequency-dependent filter element attuned to a desired frequency range from simple and cheap components.

In one aspect, boundary constraints for the assembly are also considered in the step of generating the equivalent circuit diagram and/or of transferring the equivalent circuit diagram into the frequency-dependent filter element, e.g. available space, restricted areas, where no connection element may be placed, availability of the respective component or material, weight and/or actual costs. These boundary constraints can also be considered by the machine learning method.

Although described mainly with regard to power electronics or automotive industry, the assembly and method are not limited to these technical fields. The range of use may extend e.g. from small electronic appliances to big installations such as wind energy plants and other power plants.

Preferred embodiments of the invention become apparent from the following description with regard to the enclosed figures, in which:
- Figure 1 shows a schematic side view of an assembly according to the invention, in a first variant;
- Figure 2 shows the assembly of Figure 1 in a schematic top view;
- Figure 3 shows a variant of a small-scale assembly according to the invention;
- Figure 4 shows a schematic side view of an assembly according to the invention, in a further variant;
- Figure 5 shows the assembly of Figure 4 in a schematic top view;
- Figure 6 shows an equivalent circuit diagram on which the frequency-dependent filter element of the assembly of Figure 4 is based, and the filtered frequency range;
- Figure 7 shows a circuit diagram including an electronic component emitting disturbing electromagnetic emission, an equivalent circuit diagram for a frequency-dependent filter element and several bypass components;
- Figure 8 shows the circuit diagram of Figure 7, indicating a path of a disturbing current;
- Figures 9 and 10 show an assembly according to the invention in a further variant, including an electric circuit containing the electronic component emitting disturbing electromagnetic emissions and bypass components and the resulting path of the disturbing current; and
- Figure 11 schematically shows a method according to the invention for designing the assembly according to the invention.

For reasons of clarity, identical components are not always provided with reference signs.

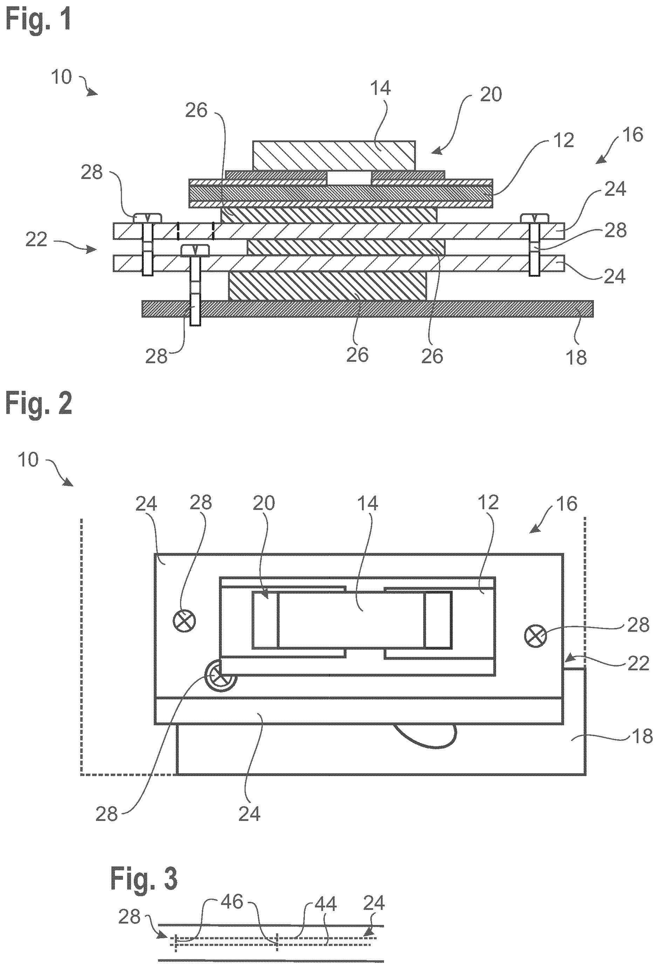

Figures 1 and 2 show an assembly 10 with a circuit substrate 12, at least one electronic component 14 mounted to the circuit substrate 12, and a frequency-dependent filter element 16. The circuit substrate 12 is accommodated in and mechanically connected to a housing 18 by the frequency-dependent filter element 16. The housing 18 is electrically connected to ground. In these examples, the housing 18 completely surrounds the assembly 10.

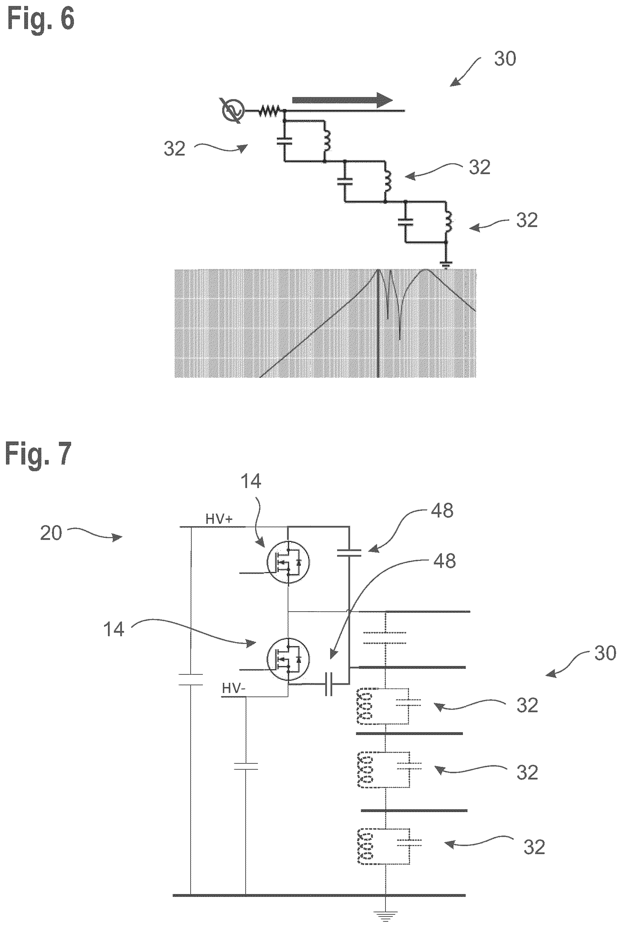

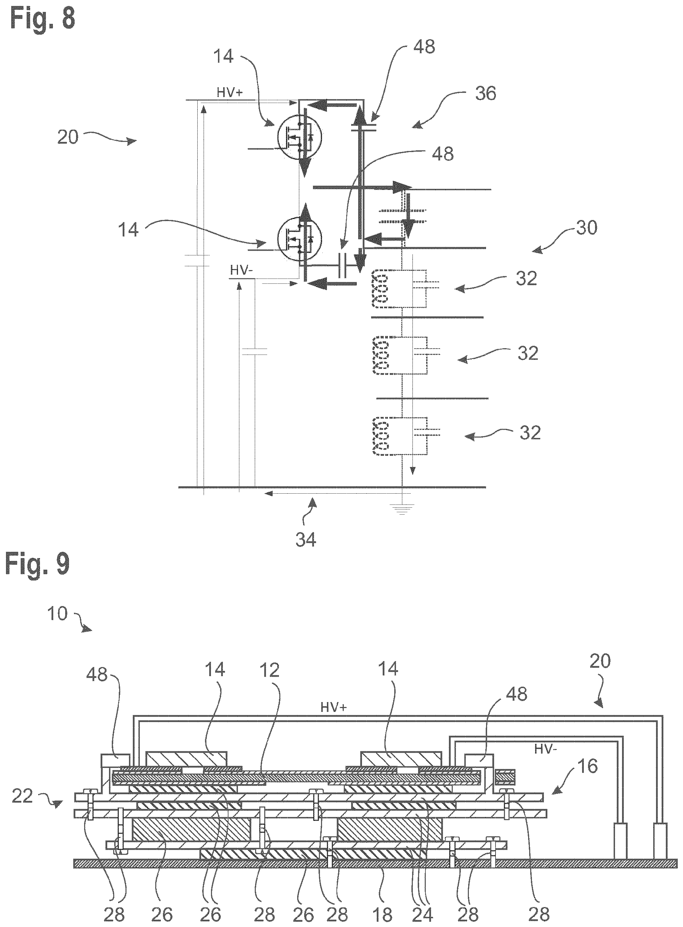

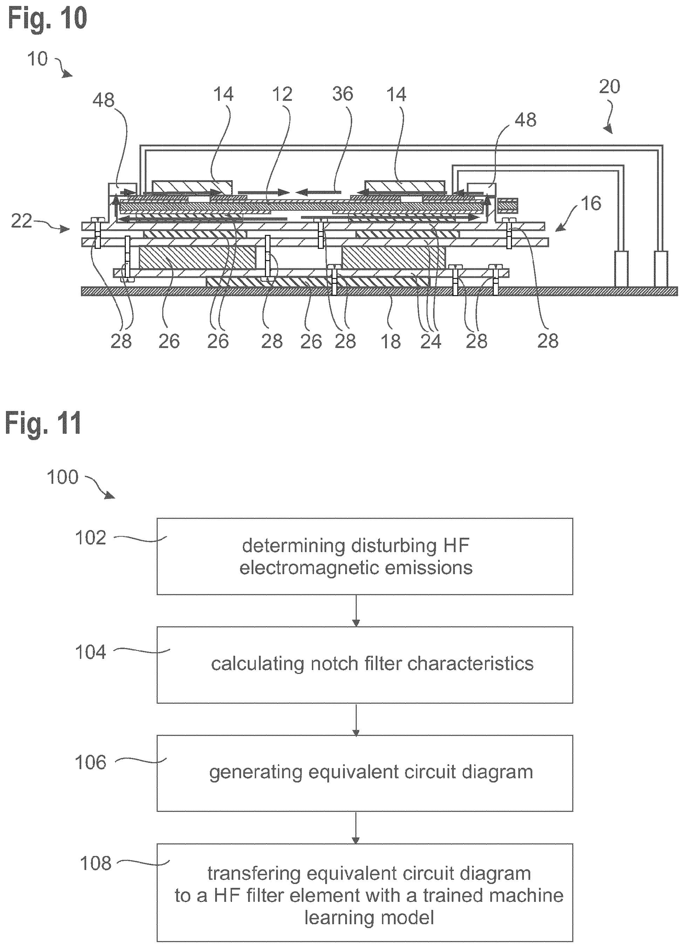

The circuit substrate 12 and the electronic component 14 are part of an electric circuit 20 (see e.g. Figure 7) and are connected to a suitable power supply (indicated in Figures 9 and 10).

In this example, the assembly 10 is arranged in an electrically driven vehicle and is connected to an electric energy storage of the vehicle. The electronic component 14 is for instance part of the power electronics of the vehicle. In one example, the electronic component 14 is an inverter, which is configured to generate a multi-phase alternating current for operating an electrical motor of the vehicle based on a direct current, which is provided by the electric power storage (not shown).

The electronic component 14 emits "noise" in form of disturbing electromagnetic emissions during operation of the electric circuit 20. The disturbing emissions usually are emitted not only in a singular frequency, but distributed over a certain frequency range. The frequency-dependent filter element 16 is attuned to the frequency range of the disturbing frequency emissions (indicated in Figure 6).

The frequency-dependent filter element 16 contains a stack 22 of at least two electrically conductive capacitance-forming elements 24 that are arranged above each other and are separated by a dielectric layer 26. The two capacitance-forming elements 24 are connected with at least one electrically conducting connection element 28. E.g., the capacitance-forming elements 24 are plate-shaped, planar or at least extend over a suitable area to be stacked with dielectric layers 26.

Also, the stack 22 is in this example connected to the housing 18 by at least one further electrically conductive connection element 28. The connection elements 28 are also part of the frequency-dependent filter element 16. A further dielectric layer 26 is arranged between the housing 18 and the adjacent capacitance-forming element 24.

All components of the frequency-dependent filter element 16 are only galvanically coupled to the electric circuit 20. The capacitance-forming elements 24, the dielectric layers 26 and the connection elements 28 act as parasitic capacitances and parasitic inductances, respectively.

In an equivalent circuit diagram 30 (see Figure 6, showing an example with three notch filters), the frequency-dependent filter element 16 may be depicted as a serial connection of two notch filters 32, where each of the notch filters 32 is attuned to a specific frequency. In combination, all notch filters 32 together can filter the desired frequency range, as indicated in Figure 6 for an example with three serially connected notch filters 32.

The frequency-dependent filter element 16 is configured to reduce a disturbance current 34 from flowing from the electric circuit 20 into the housing 18 and towards ground (indicated in Figure 8).

The impedance of the notch filters 32 is chosen to be maximal in the frequency range of the disturbing emissions of the electronic component 14. Therefore, most of a disturbing current 34 generated by these disturbing emissions is blocked from reaching the housing 18 and, instead, is redirected back into the electric circuit 20. As shown e.g. in Figures 8 and 10, a return path 36 is provided for the disturbing current 34, returning the disturbing current 34 into the electric circuit 20 on a short path and hindering the disturbing current 34 from travelling over long distances through the housing 18.

All components of the frequency-dependent filter element 16 are, in this example, commonly known mechanical mounting parts, not specific electronic components. Also, none of the components of the frequency-dependent filter element 16 are integrated into the electric circuit 20, so that the current flowing in the electric circuit 20 does not flow through any of the components of the frequency-dependent filter element 16. The frequency-dependent filter element 16 acts electrically exclusively as a combination of parasitic capacitances and inductances.

In particular, the combinations of capacitance-forming elements 24 and the dielectric layers 26 act as parasitic capacitances. The capacitance-forming elements 24 are arranged above each other and parallel to each other in the example shown here.

In the variant shown in Figures 1 and 2, the capacitance-forming elements 24 are metal plates, for instance in form of metal sheets. Other electrically conductive plates would also be suitable. An extension of the capacitance-forming elements 24 is here slightly larger than that of the circuit substrate 12.

The connection elements 28, in this example, are screws made from a suitable electrically conductive material.

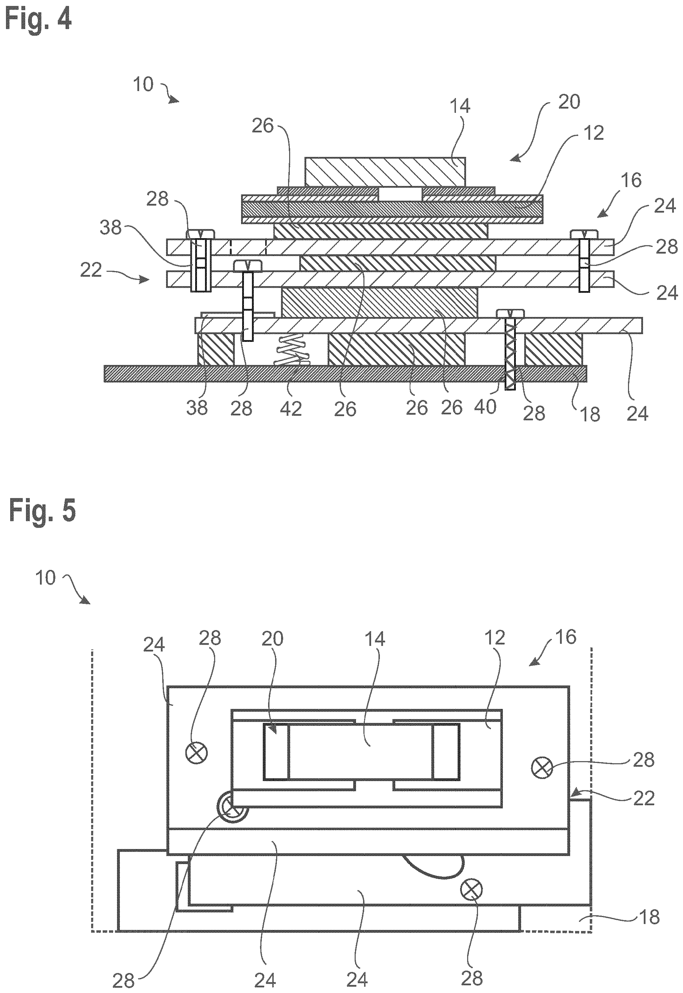

Optionally, a coating 38 of a suitable electrically isolating or electrically conductive material can be applied to any of the surfaces of any of the capacitance-forming elements 24 and/or connection elements 28 (indicated in Figure 4).

The dielectric layers 26 consist of any suitable sufficiently electrically isolating material, including air. If dielectric layers 26 are made from a thermally dissipating material, they may additionally serve to transfer heat generated by the electric circuit 20 and the electronic component 14 to the housing 18 and to cool the electronic component 14.

The filtering characteristic of the frequency-dependent filter element 16 is determined by the number, size, area, material, vertical position in the stack 22 and/or lateral position in the stack 22 of the capacitance-forming elements 24, the connection elements 28 and, to a lesser part, the dielectric layers 26. The filtering characteristics can optionally be further attuned by respective coatings 38 on one or several capacitance-forming elements 24 and/or connection elements 28. Also, the filtering characteristics can optionally be further attuned by the shape of a thread 40 on the screws acting as connection elements 28 (indicated in Figure 4).

In the variant shown in Figures 1 and 2, exactly two capacitance-forming elements 24 and three dielectric layers 26 are included in the frequency-dependent filter element 16. Exactly three connection elements 28, all formed by screws, connect the two capacitance-forming elements 24 with each other and one of the capacitance-forming elements 24 to the housing 18. The circuit substrate 12 is mechanically connected to the stack 22 by one of the dielectric layers 26, for instance by glueing.

In a further variant indicated in Figure 3, the scale of the assembly 10 is smaller than in the examples shown in Figures 1, 2, 4, 5, 8 and 9. The capacitance-forming elements 24 are here formed by individual, separate electrically conductive layers 44 of a circuit substrate. These layers are connected by one or several electrically conductive connections (vias) 46. As in the other variants, the layers 44 and connections 46 act as parasitic capacities and inductances and are only galvanically coupled to the electric circuit 20. The layers 44 optionally are formed on a circuit substrate separate from the circuit substrate 12. In another option, the layers 44 are part of the circuit substrate 12, but are not electrically directly connected to the electric circuit 20.

Figures 4 and 5 show a variant of the assembly 10 with a frequency-dependent filter element 16 containing a stack 22 of exactly three capacitance-forming elements 24. Here, four dielectric layers 26 and four connection elements 28 in form of screws in total are used to emulate three notch filters 32.

Additionally, exemplary a further connection element 28 in form of a spring 42 is shown that is arranged between the housing 18 and the adjacent capacitance-forming element 24. The spring 42 also acts as a parasitic inductance. Additional springs 42 or clamps (not shown) may optionally be included in any frequency-dependent filter element 16.

The equivalent circuit diagram 30 shown in Figures 7 and 8 includes bypass components 48, here in form of two capacitors that are electronic components integrated into the electric circuit 20. The bypass components 48 have an impedance with a minimum in the frequency range of the noise emitted from the electronic component 14. The bypass components 48 thus define the return path 36 for the disturbing current 34 and serve to reduce the portions of the disturbing current 34 coupled into the housing 18.

To design and manufacture the assembly 10, in a method 100, in a first step 102 the disturbing electromagnetic emissions of the electric circuit 20 are determined, including the emissions of the electronic component 14 (see Figure 11).

In a next step 104, the filtering characteristics of at least two serially connected notch filters 32 are calculated that are necessary to filter the disturbing emissions of the electric circuit 20.

In a step 106, an equivalent circuit diagram 30 with at least two notch filters 32, is generated that is suitable for reducing the disturbing electromagnetic emissions.

Steps 104 and 106 are in a variant performed by a simulation software that determines the values for the capacities and in inductances in the notch filters 32 and optionally also the necessary number of notch filters 32.

In a step 108, the equivalent circuit diagram 30 is transferred into the frequency-dependent filter element 16 comprising the stack 22 of at least two electrically conductive capacitance-forming elements 24 arranged above each other and separated by a dielectric layer 26, and at least two electrically conductive connection elements 28 as described above.

To transfer the equivalent circuit diagram 30 into the frequency-dependent filter element 16, suitable electrically conductive capacitance-forming elements 24, connection elements 28 and optionally dielectric layers 26, springs 42 and/or other mechanical parts being able to serve as parasitic capacitances or inductances are selected from a predetermined data set.

The predetermined data set here includes a collection of parasitic capacitances for all possible capacitance-forming elements 24 and parasitic inductances for all possible connection elements 28 and optionally dielectric layers 26 and further components such as coatings 38 and clamps. The predetermined data set also e.g. includes sizes, volumes, weight, electrical conductivity, resistance and other material electrical properties, thermal dissipation characteristics, material compatibilities and/or costs for all these components. Also included may be variations to the parasitic capacities and inductances with regard to the position of the respective component in the assembly 10, e.g. the distance of two adjacent capacitance-forming elements 24.

In this example, additionally boundary constraints are factored in, e.g. restricted areas in the assembly 10, where no connection element 28 may be positioned, material compatibilities, e.g. with regard to temperature or thermal conduction, actual cost and/or availability of the respective components.

In a variant, step 108 is carried out using a machine learning method.

It is possible to use the above described predetermined data set for training of the machine learning model by supervised learning.

Relevant features are extracted and prepared from the predetermined data set, e.g. parasitic capacitances for specific capacitance-forming elements 24 from different materials with different areas, thicknesses and/or distances to other capacitance-forming elements 24, and parasitic inductances for screws serving as connection elements 28 from different materials with different cross sections, lengths and/or thread shapes.

Optionally, further aspects are considered, e.g. different dielectric layers 26, coatings 38 or above described boundary constraints.

A suitable algorithm is chosen for the machine learning model and trained with the extracted training data and given filter characteristics for notch filter combinations of two or more serially connected notch filters, until the model is sufficiently optimized.

The trained machine learning model is then given the filter characteristics of the notch filters 32 of the equivalent circuit diagram 30 as input to find suitable combinations of capacitance-forming elements 24 and connection elements 28 and optionally other components described above, that form a frequency-dependent filter element 16 having the filter characteristics of the notch filters 32 of the equivalent circuit diagram 30.

The data for the predetermined data set may be collected in any suitable way, e.g. manually or extracted from a data collection using another suitable machine learning model.

## Claims

1. An assembly (10) comprising a housing (18), at least one circuit substrate (12), at least one electronic component (14) emitting disturbing electromagnetic emissions, and at least one frequency-dependent filter element (16) which filters disturbing electromagnetic emissions emitted from the electronic component (14),
wherein the at least one circuit substrate (12) is accommodated in the housing (18),
wherein the at least one electronic component (14) is mounted on the circuit substrate (12),
wherein the frequency-dependent filter element (16) comprises a stack (22) of at least two at least partially electrically conductive capacitance-forming elements (24) arranged above each other and separated by a dielectric layer (26), and at least one electrically conductive connection element (28), the at least two electrically conductive capacitance-forming elements (24) being mechanically coupled by the at least one electrically conductive connection element (28) to each other, to the circuit substrate (12) and/or to the housing (18), and wherein
each of the electrically conductive capacitance-forming elements (24) together with the respective at least one electrically conductive connection element (28) is part of a separate notch filter (32) attuned to a specific frequency.

2. The assembly (10) according to claim 1, wherein the frequency-dependent filter element (16) is configured to reduce a disturbing current (34) originating in the electric circuit (20) comprising the electronic component (14) and flowing through the frequency-dependent filter element (16) to the housing (18).

3. The assembly (10) according to any of the preceding claims, wherein the frequency-dependent filter element (16) is arranged so that the electrically conductive capacitance-forming elements (24) are parallel to each other and stacked with the circuit substrate (12).

4. The assembly (10) according to any of the preceding claims, wherein at least one of the electrically conductive connection elements (28) mechanically connects the stack (22) of at least two parallel electrically conductive capacitance-forming elements (24) with the housing (18).

5. The assembly (10) according to any of the preceding claims, wherein the electrically conductive capacitance-forming elements (24) comprise electrically conductive layers (44) of a circuit substrate and/or metal plates.

6. The assembly (10) according to any of the preceding claims, wherein the electrically conductive connection elements (28) comprise electrically conductive connections (46) between layers (44) of a circuit substrate, screws, springs (42) and/or clamps.

7. The assembly (10) according to claim 5 or claim 6, wherein the frequency-dependent filter element (16) further comprises coatings (38) and/or layers of thermal dissipating material.

8. A method for designing an assembly (10) according to any of the preceding claims, comprising the steps of:
- determining the disturbing electromagnetic emissions of an electric circuit (20) with at least one electronic component (14) on a circuit substrate (12),
- generating an equivalent circuit diagram (30) with at least two notch filters (32) that is suitable for reducing the disturbing electromagnetic emissions, and
- transferring the equivalent circuit diagram (30) into a frequency-dependent filter element (16) comprising a stack (22) of at least two electrically conductive capacitance-forming elements (24) arranged above each other and separated by a dielectric layer (26), and at least one electrically conductive connection element (28) mechanically coupling the capacitance-forming elements (24) to each other, to the circuit substrate (12) and/or to a housing (18), such that the frequency-dependent filter element (16) corresponds to the equivalent circuit diagram (30) in its frequency-dependent filtering properties, wherein the electrically conductive capacitance-forming elements (24) and the at least one electrically conductive connection element (28) form parts of the respective notch filters (32).

9. The method according to claim 8, wherein the step (108) of transferring the equivalent circuit diagram (30) into the frequency-dependent filter element (16) comprises selecting suitable electrically conductive capacitance-forming elements (24) and connection elements (28) from a predetermined data set with respect to capacitance, inductance, material, space requirements and/or a position of the respective component in the assembly (10).

10. The method according to claim 8 or claim 9, wherein the step (108) of transferring the equivalent circuit diagram (30) into the frequency-dependent filter element (16) is carried out using a machine learning method.
